Europäisches Patentamt

European Patent Office

Office européen des brevets

(11) Veröffentlichungsnummer: **0 226 079**
**A2**

(12) **EUROPÄISCHE PATENTANMELDUNG**

(21) Anmeldenummer: 86116265.9

(51) Int. Cl.⁴: **C08F 8/30** , G03F 7/00

(22) Anmeldetag: 24.11.86

(30) Priorität: 30.11.85 DE 3542368

(43) Veröffentlichungstag der Anmeldung:
24.06.87 Patentblatt 87/26

(84) Benannte Vertragsstaaten:
BE DE FR GB IT NL

(71) Anmelder: BASF Aktiengesellschaft
Carl-Bosch-Strasse 38
D-6700 Ludwigshafen(DE)

(72) Erfinder: Bronstert, Bernd, Dr.
Zanderstrasse 35
D-6701 Otterstadt(DE)
Erfinder: Schulz, Guenther, Dr.
Wasgaustrasse 24
D-6700 Ludwigshafen(DE)
Erfinder: Hofmann, Reiner, Dr.
Mandelbergstrasse 44
D-6730 Neustadt 23(DE)

(54) **Polyvinylalkohole mit olefinisch ungesättigten Seitengruppen sowie deren Herstellung und Verwendung, insbesondere in Offsetdruckplatten.**

(57) In wäßrigen Lösungsmitteln lösliche Polyvinylalkohole mit olefinisch ungesättigten Seitengruppen lassen sich durch Veretherung von Polyvinylalkohol mit N-Methylolamiden olefinisch ungesättigter Carbonsäuren in Gegenwart von bevorzugt sauren Veretherungskatalysatoren herstellen, wobei die Reaktanten in dünner fester, weitgehend wasser-und lösungsmittelfreier Schicht erwärmt werden. Die veretherten ungesättigten Polyvinylalkohole haben vorteilhafte Eigenschaften als Bindemittel in photoempfindlichen Aufzeichnungsmaterialien für insbesondere Druckplatten wie Offsetdruckplatten.

EP 0 226 079 A2

## Polyvinylalkohole mit olefinisch ungesättigten Seitengruppen sowie deren Herstellung und Verwendung, insbesondere in Offsetdruckplatten

Die Erfindung betrifft verbesserte Polyvinylalkohole mit olefinisch ungesättigten Seitengruppen, ihre vereinfachte Herstellung durch partielle Veretherung der Hydroxylgruppen durch Umsetzung mit N-Methylolamiden olefinisch ungesättigter Carbonsäure sowie deren Verwendung in photoempfindlichen Aufzeichnungsmaterialien für Druckformen, Reliefformen oder Resistmustern und insbesondere für Offsetdruckplatten.

Es ist z.B. aus der DE-OS 31 44 905 oder der JA-OS 79-135 526 bekannt, Polyvinylalkohole für Druckplatten oder Siebdruckschablonen zu verwenden, die olefinisch ungesättigte Seitengruppen aufweisen, die durch partielle Veresterung oder Veretherung von Hydroxylgruppen mit olefinisch ungesättigten Verbindungen wie Anhydriden oder Methylolamiden eingeführt wurden.

Jedoch ist die reproduzierbare einfache und rationelle Herstellung solcher Polyvinylalkohole mit der gewünschten Löslichkeit bzw. Auswaschbarkeit mit wäßrigen Lösungsmitteln, insbesondere Wasser, noch unbefriedigend, was sich bei ihrer Verwendung in Aufzeichnungsmaterialien für z.B. Offsetdruckplatten deutlich zeigt.

Der vorliegenden Erfindung liegt die Aufgabe zugrunde, einfach und rationell Polyvinylalkohole mit olefinisch ungesättigten Seitengruppen herzustellen, die die gewünschten Eigenschaften reproduzierbar aufweisen, was insbesondere für ihre Verwendung als Bindemittel in photopolymerisierbaren bzw. photovernetzbaren Aufzeichnungsmaterialien von ganz besonderer Bedeutung ist.

Es wurde nun gefunden, daß man in wäßrigen Lösungsmitteln lösliche Polyvinylalkohole mit olefinisch ungesättigten Seitengruppen durch Veretherung von in wäßrigen Lösungsmitteln löslichen, ggf. modifizierten Polyvinylalkoholen mit ggf. veretherten oder veresterten N-Methylolamiden olefinisch ungesättigter Carbonsäuren in Gegenwart eines Veretherungskatalysators besonders vorteilhaft herstellen kann, wenn man die Polyvinylalkohole mit 1 bis 150 und insbesondere mit 5 bis 100 Gew.% der ggf. veretherten oder veresterten N-Methylolamide in Gegenwart eines Veretherungskatalysators durch Erwärmen einer die Reaktanten enthaltenden dünnen festen und bevorzugt makroskopisch homogenen Schicht auf eine Temperatur unterhalb 150°C und bevorzugt etwa 40 bis 100°C umsetzt, wobei sich die Prozentzahlen auf die Polyvinylalkohol-Menge (vor der Umsetzung) beziehen.

Das Verfahren unterscheidet sich von den bekannten Verfahren zur Veretherung von Polyvinylalkohol mit ungesättigten Verbindungen u.a. darin, daß bevorzugt der Reaktant des Polyvinylalkohols nicht im großen Überschuß vorliegt und daß die Veretherungsreaktion in einem weitgehend wasser- und lösungsmittelfreien Medium und dennoch praktisch homogen durchgeführt wird, wobei die Veretherungsprodukte in vorteilhafter hoher Ausbeute und mit reproduzierbaren Eigenschaften entstehen.

In einer vorteilhaften Ausführungsform des erfindungsgemäßen Verfahrens wird eine Lösung einer Mischung von Polyvinylalkohol, des N-Methylolamids der olefinisch ungesättigten Carbonsäure wie N-Methylolmethacrylamid, des Veretherungskatalysators wie Phosphorsäure und bevorzugt eines Inhibitors gegen thermische Polymerisation in einem wäßrigen Lösungsmittel zu einem homogenen Film auf einem Träger vergossen und dieser getrocknet. Dabei findet eine Veretherung des Polyvinylalkohols nur in sehr geringem Maß statt, da das anwesende Wasser mit den Hydroxylgruppen des Polyvinylalkohols bzgl. einer Umsetzung mit den Methylolgruppen konkurriert. Diese Konkurrenzreaktion behindert zwar die gewünschte Umsetzung, führt aber nicht zu einem irreversiblen Verlust an Veretherungsreagenz, da die Reaktion von Methylolgruppen mit Wasser identische Methylolgruppen gibt. Tempert man nun anschließend den weitgehend wasserfreien Film bei einer Temperatur unterhalb von 150°C, bevorzugt bei 40 bis 100°C, so läßt sich das Reaktionsgleichgewicht weit auf die Seite der gewünschten Veretherungsprodukte des Polyvinylalkohols verschieben und die Ausbeuten an Veretherungsprodukt bzw. umgesetztem N-Methylolamid steigen an. Von Vorteil ist es, bei der Temperung des Films auch das bei der Veretherung entstehende Reaktionswasser herauszutrocknen, z.B. durch Erzeugen eines Unterdrucks, wodurch die Ausbeute an dem gewünschten Umsetzungsprodukt weiter erhöht werden kann. Die Ausbeuten an Veretherungsprodukt liegen im allgemeinen bei etwa 30 bis 70 Gew.%, bezogen auf das eingesetzte N-Methylolamid.

Ein besonderer Vorteil des erfindungsgemäßen Verfahrens wie auch der Verfahrensprodukte ist, daß in der praktisch homogen verlaufenden Reaktion Verfahrensprodukte mit sehr gleichmäßiger Verteilung der olefinisch ungesättigten und copolymerisierbaren bzw. photovernetzbaren Seitengruppen im Molekül entstehen, was sich positiv auf die Löslichkeit der veretherten Polyvinylalkohole im unvernetzten Zustand einerseits und positiv auf die Quellbeständigkeit der Verfahrensprodukte im photovernetzten Zustand auswirkt.

Je nach den gewählten Umsetzungsbedingungen bezüglich Menge an N-Methylolamidverbindung, Temperatur und Zeitdauer des Erwärmens sowie Entfernung entstehenden Reaktionswassers enthalten die resultierenden veretherten Polyvinylalkohole etwa 1 bis 40 Gew.% und insbesondere 10 bis 25 Gew.% an seitenständigen -CH$_2$-NH-CO-R-Gruppierungen. Nichtumgesetzte N-Methylolamidverbindungen können, sofern gewünscht, z.B. durch Dialyse vom veretherten Polyvinylalkohol getrennt werden.

In einer weiteren sehr bevorzugten Ausführungsform des erfindungsgemäßen Verfahrens kann die Umsetzung in Gegenwart eines Photopolymerisationsinitiators, eines Inhibitors für die thermische Polymerisation sowie gegebenenfalls in Gegenwart mindestens einer weiteren, bevorzugt einer nicht mit den Vinylalkohol-Struktureinheiten reagierenden photopolymerisierbaren olefinisch ungesättigten Verbindung erfolgen, wobei während der Umsetzung keine wesentliche Polymerisation erfolgen soll, d.h. daß die bei der Umsetzung resultierende Mischung noch in wäßrigen Lösungsmitteln bzw. Wasser entwickelbar bleibt bzw. keine die Verwendung beeinträchtigende Vernetzung des photopolymerisierbaren Gemischs eintritt. Dies kann insbesondere durch Art und Menge des Inhibitors für die thermische Polymerisation, Art der verwendeten Monomeren und Wahl der Umsetzungstemperatur gesteuert werden, wobei die Mitverwendung eines hinreichend wärmebeständigen Photoinitiators selbstverständliche Voraussetzung ist. Wendet man bei dieser Umsetzung die gegebenenfalls veretherten oder veresterten N-Methylolamide olefinisch ungesättigter Carbonsäuren in größerer Menge an, so kann der nicht-umgesetzte Anteil als photopolymerisierbares Monomeres in der photopolymerisierbaren Mischung verbleiben. Aus den Mischungen des Polyvinylalkohols, der N-Methylolamide, saurem Veretherungskatalysator, Photoinitiator, Inhibitor der thermischen Polymerisation sowie ggf. zusätzlichen Monomeren und üblichen Zusätzen wie Farbstoffe, Weichmacher etc. lassen sich so auf geeigneten Trägern, wie gegebenenfalls lackierten Stahl-oder Aluminiumblechen, Polyesterfolien etc., durch Gießen oder Extrudieren photoempfindliche Schichten herstellen, die nach dem Trocknen es gestatten, durch Erwärmen die Umsetzung, d.h. Veretherungsreaktion zwischen Polyvinylalkohol und N-Methylolamid so lange durchzuführen, bis das gewünschte Ausmaß der Veretherungsreaktion erreicht ist, je nach gewünschten Eigenschaften und Verwendungszwecken der so z.B. hergestellten photoempfindlichen Druckplatten.

Als in wäßrigen Lösungsmitteln lösliche Polyvinylalkohole kommen bevorzugt wasserlösliche Polyvinylalkohole mit einem Molekulargewicht von 10 kg/Mol bis 1000 kg/Mol insbesondere 15 kg/Mol bis 50 kg/Mol in Frage, wie sie durch Verseifen, Teilverseifen oder Umestern aus Vinylester-Polymerisaten oder -Copolymerisaten hergestellt werden können. Im allgemeinen beträgt der Verseifungsgrad 60 bis 99 und insbesondere 75 bis 90 Mol.%. Die restlichen Gruppen neben den Vinylalkohol-Struktureinheiten sind bevorzugt Vinylester-Struktureinheiten, insbesondere Vinylacetat-oder Vinylpropionat-Struktureinheiten, doch können es auch andere Gruppen sein, wenn z.B. Vinylester-Copolymerisate verseift oder umgeestert wurden, oder Vinylalkohol-Struktureinheiten zuvor anderweitig zur Einführung bestimmter Gruppierungen umgesetzt wurden, d.h. modifizierte Polyvinylalkohole hergestellt wurden. Gut geeignet sind auch verseifte, teilverseifte oder umgeesterte Polyalkylenoxid-Vinylester-Pfropfcopolymerisate, wie sie z.B. in den DE-PS 1 081 225 und 1 094 457 oder in der DE-OS 2 846 647 beschrieben sind, wenn sie eine hinreichende Löslichkeit in Wasser oder Wasser-Alkohol-Mischungen aufweisen.

Als gegebenenfalls veretherte oder veresterte N-Methylolamide olefinisch ungesättigter Carbonsäuren kommen solche in Frage, deren olefinische Doppelbindungen photopolymerisierbar, photocopolymerisierbar oder photovernetzbar sind. Insbesondere geeignet sind entsprechende N-Methylolamide olefinisch ungesättigter Carbonsäuren mit 3 bis 10, bevorzugt 3 bis 4 C-Atomen, wie der Crotonsäure, Maleinsäure und bevorzugt der Acryl- und Methacrylsäure. Die N-Hydroxymethyl-oder N-Methylolgruppe kann auch verethert oder verestert sein, z.B. eine N-Methoxymethylgruppe oder N-Ethoxymethylgruppe darstellen. Bevorzugt verwendet werden N-Methylolacryl-und -methacrylamid. Die Menge an N-Methylolamiden olefinisch ungesättigter Carbonsäuren beträgt 1 bis 150, insbesondere 5 bis 100 und, wenn die Umsetzung nicht in Gegenwart eines Photoinitiators und gegebenenfalls weiterer Monomerer in der photopolymerisierbaren Schicht erfolgt, bevorzugt 5 bis 30 Gew.%.

Als Veretherungskatalysatoren können die bekannten, bevorzugt sauren Veretherungskatalysatoren verwendet werden, wie saure anorganische Verbindungen. Beispiele sind anorganische Säuren, insbesondere Phosphorsäure, oder saure Salze anorganischer Säuren wie Natriumhydrogensulfat oder -dihydrogensulfat. Geeignet sind auch starke organische Säuren, insbesondere Phthalsäure, p-Toluolsulfonsäure oder Oxalsäuren. Bevorzugt sind Phosphorsäure und aromatische Sulfonsäuren. Sie werden im allgemeinen in einer Menge von 0,1 bis 5 und bevorzugt 0,5 bis 3 Gew.% der Menge der Reaktanten verwendet.

Die Dauer des Erwärmens der dünnen festen Schicht auf Temperaturen unterhalb 150°C und insbesondere 40 bis 100°C richtet sich nach Art und Menge der Reaktanten, Art und Menge des Veretherungskatalysators, dem gewünschten Veretherungsgrad des Polyvinylalkohols und der Gegenwart weiterer Verbindungen in der Schicht, die bevorzugt makroskopisch homogen sein soll, und beträgt im allgemeinen etwa 10 Min. bis etwa 3 Stunden. Sie ist durch einfache Vorversuche bei gegebenen Reaktionskomponenten und -bedingungen unschwierig zu ermitteln. Im allgemeinen erfolgt die Umsetzung in weitgehend wasserfreier Schicht, der auch keine wesentliche Menge an anorganischen und insbesondere organischen Lösungsmitteln für die Reaktanten zugesetzt wurden. Bei der Reaktion entstehendes Wasser wird bevorzugt während der Reaktion entfernt.

Die polymeren Verfahrensprodukte können in bekannter Art, z.B. Dialyse, von vorhandenen niedermolekularen Verbindungen abgetrennt und aufgearbeitet und charakterisiert werden, z.B. durch ihr IR-Spektrum oder die Bestimmung der Hydrierjodzahl.

Bezüglich der sonstigen Komponenten der photopolymerisierbaren Schicht für die erfindungsgemäße Umsetzung wie Inhibitoren der thermischen Polymerisation, Photoinitiatoren, weitere photopolymerisierbare Verbindungen, sonstige Zusätze wie Farbstoffe oder Weichmacher oder bezüglich Schichtträgern sowie der Weiterverarbeitung und Verwendung der resultierenden photopolymerisierbaren oder photovernetzbaren Aufzeichnungsmaterialien sei auf die DE-OS 31 44 905, 33 22 994 und EP-A-71 236 verwiesen.

Mit den erfindungsgemäß hergestellten Polyvinylalkoholen mit olefinisch ungesättigten Seitengruppen als polymere Bindemittel lassen sich vorteilhafte photoempfindliche Aufzeichnungsmaterialien in bekannter Art herstellen und zu Reliefformen wie Reliefdruckformen und insbesondere Offsetdruckplatten verarbeiten. Nach bildmäßiger Belichtung derselben weisen die unbelichteten Schichtanteile bevorzugt eine gute Auswaschbarkeit mit Wasser auf, die belichteten Schichtanteile durch eine verbesserte Vernetzungsdichte eine größere Quellbeständigkeit beim Entwickeln der Druckplatten. Deren Eignung für die Herstellung von wasserentwickelbaren Offsetdruckformen sei betont.

Die nachstehenden Beispiele erläutern die Erfindung. Die darin genannten Teile und Prozente beziehen sich, soweit nicht anders angegeben, auf das Gewicht. Volumenteile verhalten sich zu Teilen wie Liter zu Kilogramm.

Beispiel 1

100 Teile Polyvinylalkohol (verseiftes Polyvinylacetat; Molekulargewicht ca. 20 kg/mol; Verseifungsgrad ca. 80 Mol.%) werden in 130 Teilen Wasser gelöst. 2 Teile 2,6-Di-tert.butyl-4-methylphenol, 2 Teile 69 %ige wäßrige Phosphorsäure und 18,7 Teile N-Methylolacrylamid werden der Lösung zugesetzt und gelöst. Die resultierende Lösung wird zu einem ca. 1,5 mm dicken Film vergossen und dieser bei Raumtemperatur getrocknet. Anschließend wird der Film 1/2 Stunde bei 100°C getempert. Der Film wird in kleine Stücke geteilt, in der 9fachen Menge 0,07 %iger wäßriger Natronlauge gelöst und durch Dialyse unumgesetztes N-Methylolacrylamid abgetrennt. Die resultierende Polymerlösung wird zu einem Film von ca. 15 μm Trockendicke vergossen. Das IR-Spektrum dieses Films zeigt die Banden der Acrylamid-Gruppe bei 1650, 1620 und 1520 cm$^{-1}$. Die Bande bei 1620 cm$^{-1}$ ist der C-C-Doppelbindung zuzuordnen, ihre Extinktion beträgt etwa 8 mm$^{-1}$. Die Ausbeute an Methylolethergruppen betrug 62 %, bezogen auf N-Methylolacrylamid, entsprechend einem Gehalt von etwa 10 Gew.% an -CH$_2$-NH-CO-CH = CH$_2$-Gruppierungen im Umsetzungsprodukt.

Beispiel 2

78 Teile des gemäß Beispiel 1 hergestellten modifizierten Polyvinylalkohols werden zusammen mit 0,5 Teilen Natriumhydroxid und 0,2 Teilen des Kaliumsalzes des N-Nitrosocyclohexylhydroxylamins in 104 Teilen Wasser gelöst. Der Lösung werden 37 Teile n-Propanol, 25 Teile 1,2-Bis-(arylamidomethyloxi)-ethan, 1,2 Teile Benzildimethylketal und 0,02 Teile Duasyn Basisch Rot TH - (C.I. 50240) zugegeben. Die resultierende Lösung wird auf einem Stahlblech zu einer ca. 1,5 mm dicken Schicht vergossen und bei Raumtemperatur getrocknet. Die Schichten werden dann unter einem Negativ wie üblich bildmäßig belichtet und die unbelichteten Schichtanteile mit Wasser bei ca. 40°C ausgewaschen. Die belichteten Schichtanteile zeichnen sich durch eine hervorragende Auswasch- und Quellbeständigkeit und das resultierende Relief durch gute mechanische Eigenschaften beim Druck aus.

### Beispiel 3

Es wird wie in Beispiel 1 verfahren, jedoch werden anstelle des 2,6-Di-tert.butyl-4-methylphenols 0,3 Teile des Kaliumsalzes des N-Nitrosocyclohexylhydroxylamins verwendet und der vergossene Film 1 Stunde bei 100°C unter Stickstoff getempert. Das IR-Spektrum des dünnen Polymerfilms zeigt bei 1620 cm$^{-1}$ eine Extinktion von ca. 17 mm$^{-1}$. Das resultierende Umsetzungsprodukt hat einen Gehalt von etwa 19,5 Gew.% an -CH$_2$-NH-CO-CH=CH$_2$-Gruppierungen.

### Beispiel 4

Es wird wie in Beispiel 1 verfahren, jedoch werden 100 Teile eines Polyvinylalkohols mit einem Molekulargewicht von ca. 25 kg/mol und einem Verseifungsgrad von 88 Mol.% sowie 22,8 Teile an N-Methylolmethacrylamid verwandt. Das IR-Spektrum des resultierenden dünnen Polymerfilms zeigt bei 1620 cm$^{-1}$ eine Extinktion von ca. 9 mm$^{-1}$. Das resultierende Umsetzungsprodukt hat einen Gehalt von etwa 11 Gew.% an -CH$_2$-NH-CO-C(CH$_3$)=CH$_2$-Gruppen. Die Ausbeute beträgt 50 Mol%, bezogen auf das eingesetzte N-Methylolmethacrylamid.

### Beispiel 5

Es wird wie in Beispiel 1 verfahren, jedoch werden 100 Teile eines Polyvinylalkohols mit einem Molekulargewicht von ca. 25 kg/mol und einem Verseifungsgrad von ca. 82 Mol.% sowie 10,7 Teile an N-Methylolmethacrylamid verwandt. Das IR-Spektrum des resultierenden dünnen Polymerfilms zeigt bei 1620 cm$^{-1}$ eine Extinktion von ca. 7 mm$^{-1}$. Das Umsetzungsprodukt hat einen Gehalt von etwa 8 Gew.% an -CH$_2$-NH-CO-C(CH$_3$)=CH$_2$-Gruppen.

### Beispiel 6

Es wird wie in Beispiel 1 verfahren, jedoch werden 100 Teile eines teilverseiften Pfropfcopolymerisats von Vinylacetat auf Polyethylenoxid, das einen Anteil von Oxiethylengruppen von ca. 25 % sowie ein Gesamtmolekulargewicht von ca. 24 kg/mol hat und bei dem die Acetatgruppen zu ca. 80 Mol.% verseift wurden, verwendet. Ferner werden 14,5 Teile N-Methylolmethacrylamid sowie als Veretherungskatalysator 2 Teile p-Toluolsulfonsäure verwandt. Das IR-Spektrum des resultierenden dünnen Polymerfilms zeigt bei 1620 cm$^{-1}$ eine Extinktion von ca. 18 mm$^{-1}$.

### Beispiel 7

78 Teile des gemäß Beispiel 6 hergestellten modifizierten Pfropfcopolymerisats werden wie in Beispiel 2 angegeben zu Reliefdruckplatten verarbeitet, jedoch wird ein Aluminiumblech als Träger verwendet. Die Klischees haben auch nach längerer Lagerung eine geringe Sprödigkeit.

### Beispiel 8

Eine Mischung von 67 Teilen von zu 80 Mol.% verseiftem Polyvinylacetat (Molekulargewicht ca. 20 kg/mol), 1,5 Teilen p-Toluolsulfonsäure, 0,5 Teilen des Kaliumsalzes des N-Nitrosocyclohexylhydroxylamins, 30 Teilen N-Methylolacrylamid, 1,2 Teilen Benzildimethylketal, 0,02 Teilen Duasyn Basisch Rot TH (C.I. 50240) und 0,03 Teilen Rhodamin B - (C.I. 45170) werden in 170 Teilen Wasser gelöst. Die Lösung wird auf einem Aluminiumblech als Träger zu einer 1 bis 2 mm dicken Schicht vergossen und bei Raumtemperatur getrocknet. Dann werden die so hergestellten Rohplatten etwa 1,5 Stunden auf 90°C erwärmt. Die Platten werden dann bildmäßig mit UV-Licht belichtet und mit Wasser ausgewaschen. Die resultierenden Druckreliefs zeigen in den belichteten Bereichen eine sehr gute Quellbeständigkeit und gute mechanische Eigenschaften.

### Beispiel 9

Es wird wie in Beispiel 8 verfahren, jedoch werden anstelle des dort angegebenen verseiften Polyvinylacetats 77 Teile eines Pfropfcopolymerisats von Vinylacetat auf Polyethylenoxid - (Molekulargewicht etwa 35 kg/mol), dessen Acetatgruppen zu ca. 80 Mol.% verseift wurden und dessen Anteil an Ethylenoxid-Einheiten 25 % betrug, verwendet, statt N-Methylolacrylamid werden 20 Teile N-Methylolmethacrylamid und statt p-Toluolsulfonsäure 1,5 Teile einer 69 %igen wäßrigen Phosphorsäure als Veretherungskatalysator verwendet. Die resultierenden Druckreliefs sind auch nach längerer Lagerung nicht spröde und haben gute mechanische Eigenschaften. Das Auswaschen der bildmäßig belichteten Platte erfolgt mit verdünnter wäßriger Natriumbicarbonatlösung.

### Beispiel 10

100 Teile eines Pfropfcopolymerisats von Vinylacetat auf Polyethylenoxid (Anteil an Ethylenoxid-Einheiten 50 %; Molekulargewicht ca. 16 kg/mol), dessen Acetatgruppen zu ca. 85 Mol.% verseift sind, werden zusammen mit 0,25 Teilen 2,6-Di-tert.butyl-4-methylphenol in 175 Teilen Wasser gelöst und der Lösung 0,04 Teile des Kaliumsalzes des N-Nitrosocyclohexylhydroxylamins, 33 Teile N-Methylolmethacrylamid und 1,3 Teile Phosphorsäure zugegeben. Der aus dieser Lösung gegossene und getrocknete 1 bis 2 mm dicke Film auf einem Aluminiumblech wird 2 Stunden bei 80°C getempert. Das IR-Spektrum des resultierenden Produkts zeigt bei 1625 cm$^{-1}$ eine Extinktion von ca. 11 mm$^{-1}$.

### Beispiel 11

45 Teile eines wasserlöslichen Polyvinylalkohols (Verseifungsgrad 83 Mol.%; Molekulargewicht 25 kg/mol), hergestellt aus Polyvinylacetat, 35 Teile N-Methylolacrylamid, 7,5 Teile Benzildimethylketal, 0,5 Teile Phosphorsäure und 1 Teil Rhodamin B - (C.I. 45170) werden in einem Wasser-Isopropanol - (70:30)-Gemisch zu einer 10 %igen Lösung gelöst. Die Lösung wird so auf ein Offset-typisches Aluminiumblech aufgegossen, daß nach Ablüften des Lösungsmittelgemisches und Tempern der getrockneten Schicht während 15 Min. bei 80°C eine Trockenschichtdicke von 2,0 μm resultiert.

Die so hergestellte Offsetdruckplatte wird mit einem 1 m entfernten 3 Kilowatt-Halogenid-Hochdruckbrenner 25 Sek. lang durch ein Standardnegativ bildmäßig belichtet und dann mit Leitungswasser mit pH-Wert von 7 in einem Durchlaufwascher 25 Sek. lang entwickelt. Nach dem üblichen Gummieren werden mit der so erhaltenen Offsetdruckform in einer Offset-Druckmaschine ausgezeichnete Druckergebnisse erzielt, wobei auch nach langer Druckzeit keine Abriebspuren zu erkennen sind.

### Beispiel 12

43 Teile eines aus Polyvinylacetat hergestellten Polyvinylalkohols (Verseifungsgrad 80 Mol.%; Molekulargewicht ca. 20 kg/mol), 43 Teile N-Methylolacrylamid, 5 Teile 1,1,1-Trimethylolpropan-triacrylat, 7 Teile Benzildimethylketal, 0,2 Teile des Kaliumsalzes von N-Nitroso-cyclohexylhydroxylamin, 0,5 Teile 69 %ige wäßrige Phosphorsäure, 1 Teil Bengal-Rosa (C.I. 45440) und 0,5 Teile Rhodamin B (C.I. 45170) werden wie in Beispiel 11 in einem Wasser-Isopropanol (70:30)-Gemisch gelöst und mit der Lösung und einem Träger wird wie in Beispiel 11 eine Offsetdruckplatte und eine Offsetdruckform hergestellt. Die bildmäßig belichtete Offsetdruckform zeichnet sich durch eine hervorragende Auswaschbeständigkeit und Beständigkeit gegen Wischwasser (pH ca. 4,5 bis 5,5) aus. Die mechanischen Eigenschaften der Offsetdruckform und die Empfindlichkeit der Offsetdruckplatte sind noch besser als die gemäß Beispiel 11 hergestellten.

### Beispiel 13

Es wird wie in Beispiel 12 verfahren, jedoch werden anstelle von N-Methylolacrylamid die gleiche Menge von N-Methylolmethacrylamid und anstelle von 0,5 Teilen jetzt 1,5 Teile der 69 %igen Phosphorsäure als Veretherungskatalysator verwendet. Die resultierenden Druckklischees zeigen ähnlich gute Eigenschaften wie die gemäß Beispiel 12 hergestellten.

### Ansprüche

1. Verfahren zur Herstellung von in wäßrigen Lösungsmitteln löslichen Polyvinylalkoholen mit olefinisch ungesättigten Seitengruppen durch Veretherung von in wäßrigen Lösungsmitteln löslichen, gegebenenfalls modifizierten Polyvinylalkoholen mit gegebenenfalls veretherten oder veresterten N-Methylolamiden olefinisch ungesättigter Carbonsäuren in Gegenwart eines Veretherungskatalysators, dadurch gekennzeichnet, daß man die Polyvinylalkohole mit 1 bis 150 Gew.% der gegebenenfalls veretherten oder veresterten N-Methylolamide in Gegenwart eines Veretherungskatalysators durch Erwärmen einer die Reaktanten enthaltenden dünnen festen Schicht auf Temperaturen bis etwa 150°C umsetzt, wobei sich die Prozentzahlen auf die eingesetzte Polyvinylalkohol-Menge beziehen.

2. Verfahren nach Anspruch 1, dadurch gekennzeichnet, daß man die Polyvinylalkohole mit 5 bis 100 Gew.% ihrer Menge an gegebenenfalls veretherten oder veresterten N-Methylolamiden umsetzt.

3. Verfahren nach Anspruch 1 oder 2, dadurch gekennzeichnet, daß man die Umsetzung in makroskopisch homogener Schicht durchführt.

4. Verfahren nach einem der Ansprüche 1 bis 3, dadurch gekennzeichnet, daß man die Umsetzung in weitgehend wasserfreier und lösungsmittelfreier Schicht durchführt.

5. Verfahren nach einem der Ansprüche 1 bis 4, dadurch gekennzeichnet , daß man die Schicht für die Umsetzung je nach Schichtdicke etwa 10 Minuten bis 3 Stunden erwärmt.

6. Verfahren nach einem der Ansprüche 1 bis 5, dadurch gekennzeichnet, daß man die Umsetzung in Gegenwart eines Photopolymerisationsinitiators, eines Inhibitors für die thermische Polymerisation sowie gegebenenfalls mindestens einer weiteren photopolymerisierbaren olefinisch ungesättigten Verbindung so durchführt, daß keine wesentliche Polymerisation erfolgt.

7. In wäßrigen Lösungsmitteln löslicher Polyvinylalkohol, dessen Hydroxylgruppen partiell mit einem gegebenenfalls veretherten oder veresterten N-Methylolamid einer olefinisch ungesättigten Carbonsäure in Gegenwart eines Veretherungskatalysators umgesetzt wurden, dadurch gekennzeichnet, daß die Umsetzung mit 1 bis 150 Gew.% des gegebenenfalls veretherten oder veresterten N-Methylolamids in Gegenwart des Veretherungskatalysators durch Erwärmen einer die Reaktanten enthaltenden dünnen festen Schicht auf eine Temperatur unterhalb 150°C erfolgte, wobei sich die Prozentzahlen auf die Polyvinylalkohol-Menge vor der Umsetzung beziehen.

8. Verwendung von Polyvinylalkoholen gemäß Anspruch 7 in photoempfindlichen Aufzeichnungsmaterialien für die Herstellung von Druckformen, Reliefformen oder Resistmustern.

9. Offsetdruckplatten mit einem Träger und einer Polyvinylalkohol enthaltenden photoempfindlichen Aufzeichnungsschicht, dadurch gekennzeichnet, daß die Aufzeichnungsschicht einen in wäßrigen Lösungsmitteln löslichen Polyvinylalkohol mit olefinisch ungesättigten Seitengruppen enthält, der durch partielle Veretherung von Hydroxylgruppen des Polyvinylalkohols durch Umsetzung mit 1 bis 150 Gew.% mindestens eines gegebenenfalls veretherten oder veresterten N-Methylolamids einer olefinisch ungesättigten Carbonsäure in Gegenwart eines Veretherungskatalysators durch Erwärmen einer die Reaktanten enthaltenden dünnen festen Schicht auf eine Temperatur unterhalb 150°C hergestellt ist, wobei sich die Prozentzahlen auf die Polyvinylalkohol-Menge vor der Umsetzung beziehen.